# FASCICULE DE BREVET EUROPEEN

(11) **EP 2 071 729 B1**
(45) Date de publication et mention de la délivrance du brevet: **18.08.2010**
(21) Numéro de dépôt: 07122935.5
(22) Date de dépôt: 11.12.2007
(51) Int. Cl.: H03K 23/66

(54) **Circuit compteur-diviseur double mode pour opérer à très haute fréquence**
Zähler-Verteiler-Schaltung mit Doppelmodus für Hochfrequenzbetrieb
Dual-mode counter-divider circuit for very high frequency operation

(43) Date de publication de la demande: 17.06.2009
(73) Titulaire: The Swatch Group Research and Development Ltd., 2074 Marin (CH)
(72) Inventeur: Casagrande, Arnaud, 2068 Hauterive (CH); Velasquez, Carlos, 2000 Neuchâtel (CH); Arend, Jean-Luc, 2000 Neuchâtel (CH)
(74) Mandataire: Couillard, Yann Luc Raymond

(56) Documents cités:
- US-A- 5 020 082
- US-B1- 6 614 274
- HAMID R RATEGH ET AL: "A CMOS Frequency Synthesizer with an Injection-Locked Frequency Divider for a 5-GHz Wireless LAN Receiver" IEEE JOURNAL OF SOLID-STATE CIRCUITS, IEEE SERVICE CENTER, PISCATAWAY, NJ, US, vol. 35, no. 5, mai 2000 (2000-05), XP011061248 ISSN: 0018-9200

## Description

L'invention concerne un circuit compteur-diviseur double mode pour opérer à très haute fréquence notamment disposé dans une boucle à verrouillage de phase d'un synthétiseur de fréquence. Le circuit compteur-diviseur comprend au moins un ensemble composé de deux bascules dynamiques de type D, et de deux portes logiques disposées en contre-réaction entre les deux bascules. Ces deux bascules sont cadencées par un signal d'horloge d'entrée afin de fournir un signal de sortie dont la fréquence correspond à la fréquence du signal d'horloge d'entrée divisée par un premier facteur égal à 2, ou par un second facteur égal à 3 en fonction d'un mode de division sélectionné.

Il est à noter qu'on entend par signaux à très haute fréquence, des signaux ayant une fréquence supérieure à 1 GHz. Cette très haute fréquence est par exemple une fréquence porteuse d'un canal de transmission sur laquelle des données à transmettre sont modulées dans des signaux générés en sortie d'un oscillateur commandé en tension d'un synthétiseur de fréquence. De tels signaux sont donc utilisés dans des systèmes de communication sans fil, tels que dans un réseau cellulaire de communication.

Un synthétiseur de fréquence comprend traditionnellement une boucle à verrouillage de phase, dans laquelle un circuit compteur-diviseur double mode permet de diviser la fréquence des signaux de sortie du synthétiseur par un premier facteur ou par un second facteur en fonction d'un mode de division sélectionné. La sélection de mode est réalisée par exemple par un modulateur, tel qu'un modulateur sigma delta de manière que le synthétiseur produise en sortie des signaux à fréquence souhaitée dans une bande de fréquence déterminée.

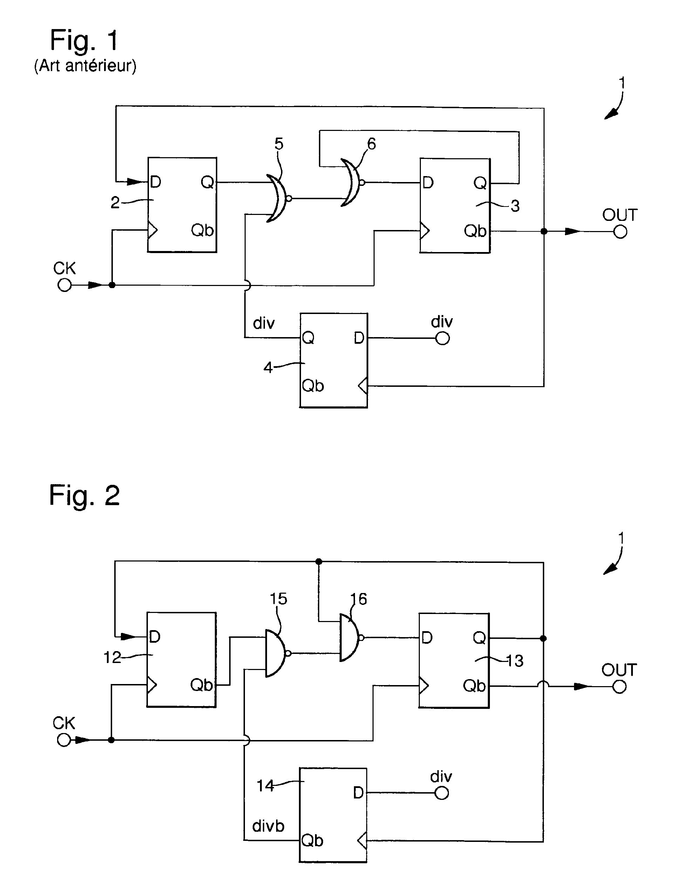

A la figure 1, il est représenté un circuit compteur-diviseur double mode 1 traditionnel. Ce circuit est capable d'effectuer une division de fréquence d'un signal d'entrée CK par un premier facteur égal à 2 ou par un second facteur égal à 3 en fonction d'un mode sélectionné div.

Pour ce faire, ce circuit compteur-diviseur peut comprendre deux ou trois bascules de type D standard 2, 3, 4, ainsi que deux portes logiques du type OU inversé 5, 6 en contre-réaction et disposées entre une première bascule 2 et une seconde bascule 3. Chacune de ces bascules est susceptible de fournir un signal de sortie non inversée Q et un signal de sortie inversée Qb en fonction d'un signal d'entrée D. Les première et seconde bascules 2 et 3 sont cadencées par le signal d'horloge d'entrée CK. Une troisième bascule 4 cadencée par un signal de sortie OUT de la seconde bascule 3, peut être également prévue. Cette troisième bascule 4 n'est utilisée que pour assurer une bonne re-synchronisation lors du changement de mode div. La fréquence de ce signal de sortie OUT du circuit compteur-diviseur 1 correspond à la fréquence du signal d'entrée CK divisée par le premier facteur de division ou le second facteur de division en fonction du mode sélectionné div.

La première porte logique OU inversé 5 (NOR en terminologie anglaise) reçoit en entrée le signal de sortie non inversée Q de la première bascule 2, ainsi que le signal de sortie non inversée Q de la troisième bascule 4 représentant la sélection de mode de division div. La sortie de cette première porte logique 5 est reliée à une entrée de la seconde porte logique OU inversé 6, qui reçoit également en entrée le signal de sortie non inversée Q de la seconde bascule 3. La sortie de cette seconde porte logique 6 est reliée en entrée D de la seconde bascule 3. Le signal de sortie OUT du circuit compteur-diviseur 1 est fourni à la sortie inversée Qb de la seconde bascule 3. Ce signal de sortie OUT constitue également le signal d'entrée D de la première bascule 2.

Dans le cas où le mode sélectionné div est à l'état 1, c'est-à-dire à l'état haut en tension, le circuit compteur-diviseur 1 permet de diviser la fréquence du signal d'entrée CK par un premier facteur égal à 2. Par contre si le mode sélectionné div est à l'état 0, c'est-à-dire à l'état bas en tension, le circuit compteur-diviseur 1 permet de diviser la fréquence du signal d'entrée CK par un second facteur égal à 3.

Chaque porte logique OU inversé 5, 6 est réalisée avec deux transistors PMOS en série, qui sont reliés en série avec deux transistors NMOS en parallèle entre une borne d'alimentation positive et une borne d'alimentation négative d'une source de tension. Une grille du premier transistor PMOS est reliée à une grille du premier transistor NMOS pour constituer une première entrée de la porte. Une grille du second transistor PMOS est reliée à une grille du second transistor NMOS pour constituer une seconde entrée de la porte. Le noeud de connexion entre les transistors PMOS et les transistors NMOS constitue la sortie de la porte logique.

De par l'utilisation de portes logiques du type OU inversé ayant deux transistors PMOS en série qui sont lents, un tel circuit compteur-diviseur n'est pas prévu pour fonctionner normalement à très haute fréquence, ce qui constitue un inconvénient. De plus, comme trois bascules du type D standard sont utilisées, ce circuit compteur-diviseur consomme une quantité importante d'énergie électrique.

Le document US 5020082 montre un circuit diviseur selon le préambule de la revendication 1.

L'invention a donc pour but de fournir un circuit compteur-diviseur double mode qui pallie les inconvénients de l'état de la technique susmentionnés, avec une structure relativement simple réalisée dans une technologie CMOS et fonctionnant à très haute fréquence.

A cet effet, l'invention concerne un circuit compteur-diviseur double mode cité ci-devant, qui comprend les caractéristiques définies dans la revendication indépendante 1.

Des formes particulières d'exécution du circuit compteur-diviseur sont définies dans les revendications dépendantes 2 à 8.

Un avantage du circuit compteur-diviseur selon l'invention est qu'il comprend deux portes logiques du type ET inversé, qui sont réalisées avec deux transistors NMOS en série, qui sont reliés en série à deux transistors PMOS en parallèle entre deux bornes d'une source de tension continue. Comme la commutation de chaque transistor NMOS est rapide par rapport à la commutation de chaque transistor PMOS, chaque porte logique de type ET inversé permet de réaliser un circuit compteur-diviseur susceptible d'opérer à très haute fréquence.

Une des deux bascules ne fournit avantageusement qu'un seul signal de sortie par une sortie inversée, ce qui permet de réaliser cette bascule avec une branche active en moins d'une bascule de type D standard pour réduire la consommation électrique dudit circuit. Les bascules de type D sont avantageusement des bascules dynamiques pour le circuit compteur-diviseur double mode capable de fonctionner à très haute fréquence.

Les buts, avantages et caractéristiques du circuit compteur-diviseur double mode apparaîtront mieux dans la description suivante sur la base d'au moins une forme d'exécution non limitative illustrée par les dessins sur lesquels :
la figure 1 déjà citée représente de manière simplifiée une forme d'exécution d'un circuit compteur-diviseur double mode de l'état de la technique,
la figure 2 représente de manière simplifiée une forme d'exécution d'un circuit compteur-diviseur double mode selon l'invention,
la figure 3 représente une forme de réalisation d'une bascule dynamique de type D comprenant une sortie inversée et une sortie non inversée pour un circuit compteur-diviseur selon l'invention, et
la figure 4 représente une forme de réalisation d'une bascule dynamique de type D à phase unique comprenant une seule sortie inversée pour un compteur-diviseur selon l'invention.

Dans la description suivante, le circuit compteur-diviseur double mode est conçu normalement pour être capable de fonctionner à très haute fréquence notamment dans une boucle à verrouillage de phase d'un synthétiseur de fréquence. Bien entendu, il peut comprendre également en plus de l'ensemble diviseur par 2 ou par 3, une chaîne de diviseurs reliée de préférence en sortie de l'ensemble. Le circuit peut donc diviser la fréquence d'un signal à très haute fréquence par un premier facteur N, où N est au moins un nombre entier plus grand ou égal à 2, ou par un second facteur N+M, où M est au moins un nombre entier plus grand ou égal à 1.

A la figure 2, il est représenté une structure simplifiée d'un circuit compteur-diviseur double mode 1 selon l'invention capable d'opérer à très haute fréquence, par exemple pour diviser une fréquence de l'ordre de 2.45 GHz. Ce circuit compteur-diviseur comprend au moins un ensemble, qui est composé de deux bascules dynamiques de type D 12 et 13, et de deux portes logiques de type ET inversé 15 et 16 (NAND en terminologie anglaise). Ces portes logiques sont disposées en contre-réaction entre les deux bascules 12, 13. Cet ensemble constitue l'étage d'entrée du circuit compteur-diviseur, qui peut comprendre à la suite de cet ensemble plusieurs diviseurs par 2 par exemple.

Les bascules 12 et 13 sont cadencées par un signal d'horloge d'entrée CK afin que l'ensemble du circuit compteur-diviseur fournisse un signal de sortie OUT. De préférence, ce signal de sortie est fourni à la sortie inversée Qb de la seconde bascule 13. La fréquence de ce signal de sortie OUT correspond à la fréquence du signal d'horloge d'entrée divisée par un premier facteur égal à 2, ou par un second facteur égal à 3 en fonction d'un mode de division div sélectionné.

L'ensemble du circuit compteur-diviseur 1 peut comprendre également une troisième bascule dynamique 14 comme montré sur cette figure 2. Cette troisième bascule dynamique permet d'avoir une bonne re-synchronisation lors du changement de mode de division div, qui peut survenir rapidement à haute fréquence. Cette troisième bascule est cadencée par un signal de sortie de la seconde bascule 13. Dans cette forme d'exécution, le signal de sortie non inversée Q de la seconde bascule 13 cadence la troisième bascule 14. Bien entendu, il pourrait aussi être imaginé d'opérer la sélection de mode par le signal divb sans l'utilisation de cette troisième bascule à plus basse fréquence.

La première porte logique ET inversé 15 reçoit en entrée le signal de sortie inversée Qb de la première bascule 12, ainsi que le signal de sortie inversée Qb de la troisième bascule 14 représentant la sélection inversée de mode de division divb. La sortie de cette première porte logique 15 est reliée à une entrée de la seconde porte logique ET inversé 16, qui reçoit également en entrée le signal de sortie non inversée Q de la seconde bascule 13. La sortie de cette seconde porte logique 16 est reliée en entrée D de la seconde bascule 13. Le signal de sortie non inversée Q de la seconde bascule 13 constitue également le signal d'entrée D de la première bascule 12. Le signal de sortie OUT du circuit compteur-diviseur 1 peut être fourni à la sortie inversée Qb de la seconde bascule 13.

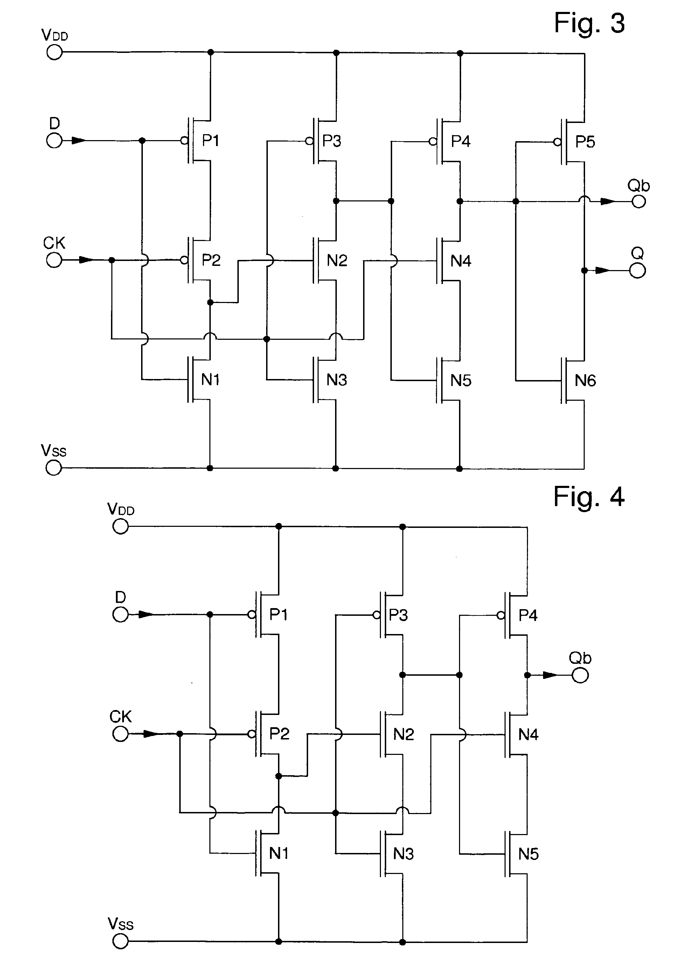

Comme expliqué par la suite en référence aux figures 3 et 4, il est préférable de fournir le signal de sortie OUT par la sortie inversée Qb de la seconde bascule dynamique 13. Dans ce cas, moins de branches actives entre l'entrée CK du circuit compteur-diviseur 1 et la sortie OUT sont utilisées pour opérer une division à très haute fréquence. La première bascule dynamique 12 à phase unique est également prévue pour ne fournir que le signal de sortie inversée Qb, ce qui économise une branche active par rapport à une bascule de type D standard, et réduit de ce fait la consommation électrique du circuit compteur-diviseur 1. Il en est de même pour la troisième bascule 14.

Dans le cas où le mode sélectionné div est à l'état 1, c'est-à-dire à l'état haut, le circuit compteur-diviseur 1 permet de diviser la fréquence du signal d'entrée CK par un premier facteur égal à 2. Par contre si le mode sélectionné div est à l'état 0, c'est-à-dire à l'état bas, le circuit compteur-diviseur 1 permet de diviser la fréquence du signal d'entrée CK par un second facteur égal à 3.

Les portes logiques du type ET inversé peuvent être réalisées chacune avec deux transistors NMOS en série, qui sont reliés en série à deux transistors PMOS en parallèle entre deux bornes d'une source de tension continue, non représentés. Une grille du premier transistor NMOS est reliée à une grille du premier transistor PMOS pour constituer une première entrée de la porte logique. Une grille du second transistor NMOS est reliée à une grille du second transistor PMOS pour constituer une seconde entrée de la porte logique. Le noeud de connexion de drain entre les transistors NMOS et PMOS constitue la sortie de la porte logique. Comme la commutation de chaque transistor NMOS est très rapide par rapport à la commutation de chaque transistor PMOS, chaque porte logique de type ET inversé permet de réaliser un circuit compteur-diviseur susceptible d'opérer à très haute fréquence.

Le circuit compteur-diviseur peut être avantageusement réalisé sous forme intégrée dans un substrat de silicium normalement dopé P dans une technologie CMOS à 0.18 µm.

Aux figures 3 et 4, il est représenté une forme d'exécution d'une bascule dynamique du type D à deux sorties Q et Qb vue à la figure 3, et une forme d'exécution d'une bascule dynamique du type D à une seule sortie inversée Qb vue à la figure 4. Cette bascule dynamique dénommée TSP (True Single Phase en terminologie anglaise) est avantageusement utilisée pour le circuit compteur-diviseur double pour un fonctionnement à très haute fréquence (supérieure à 1 GHz) et une réduction de consommation électrique.

Tout d'abord à la figure 3, la bascule dynamique du type D à deux sorties Q et Qb est celle utilisée comme seconde bascule 13 montrée à la figure 2. Cette bascule dynamique comprend trois branches actives composées chacune de trois transistors MOS en série et d'une branche active finale composée de deux transistors MOS en série. Ces transistors MOS sont disposés entre deux bornes V_{DD} et V_{SS} d'une source de tension continue d'alimentation du circuit compteur-diviseur double mode.

Une première branche active comprend donc en série un premier transistor PMOS P1, un second transistor PMOS P2 et un premier transistor NMOS N1. La source du premier transistor PMOS P1 est reliée à la borne positive V_{DD} et son drain est relié à la source du second transistor PMOS P2. Le drain de ce second transistor PMOS P2 est relié au drain du premier transistor NMOS N1, dont la source est reliée à la borne négative V_{SS.} Les grilles des premiers transistors PMOS P1 et NMOS N1 sont reliées pour définir la borne d'entrée D de la bascule. La grille du second transistor PMOS P2 reçoit le signal d'horloge d'entrée CK, dont la fréquence est à diviser dans le circuit compteur-diviseur.

Une seconde branche active comprend donc en série un troisième transistor PMOS P3, un second transistor NMOS N2 et un troisième transistor NMOS N3. La source du troisième transistor PMOS P3 est reliée à la borne positive V_{DD} et son drain est relié au drain du second transistor NMOS N2. La source de ce second transistor NMOS N2 est reliée au drain du troisième transistor NMOS N3, dont la source est reliée à la borne négative V_{SS}. Les grilles des troisièmes transistors PMOS P3 et NMOS N3 sont reliées pour recevoir le signal d'horloge d'entrée CK. La grille du second transistor NMOS N2 est par contre reliée au drain de premier transistor NMOS N1 et du second transistor PMOS P2.

Une troisième branche active comprend donc en série un quatrième transistor PMOS P4, un quatrième transistor NMOS N4 et un cinquième transistor NMOS N5. La source du quatrième transistor PMOS P4 est reliée à la borne positive V_{DD} et son drain est relié au drain du quatrième transistor NMOS N4. La source de ce quatrième transistor NMOS N4 est reliée au drain du cinquième transistor NMOS N5, dont la source est reliée à la borne négative V_{SS}. Les grilles du quatrième transistor PMOS P4 et du cinquième transistor NMOS N5 sont reliées au drain du second transistor NMOS N2 et du troisième transistor PMOS P3. La grille du quatrième transistor NMOS N4 reçoit le signal d'horloge d'entrée CK. Une sortie inversée Qb de la bascule peut être obtenue au noeud de connexion des drains des quatrièmes transistors PMOS P4 et NMOS N4.

Finalement, une quatrième branche active représente un étage inverseur. Cette quatrième branche comprend donc en série, entre les deux bornes d'alimentation V_{DD} et V_{SS}, un cinquième transistor PMOS P5 et un sixième transistor NMOS N6. La source du cinquième transistor PMOS P5 est reliée à la borne positive V_{DD} et son drain est relié au drain du sixième transistor NMOS N6 définissant le noeud de sortie non inversée Q. La source du sixième transistor NMOS N6 est reliée à la borne négative V_{SS}.

Bien entendu dans le cas où il est souhaité réaliser une bascule dynamique de type simplifiée à une seule sortie inversée Qb représentée à la figure 4, cette dernière branche active, comme étage inverseur, est supprimée. Ceci permet de réduire la consommation électrique d'une telle bascule. De ce fait, comme le circuit compteur-diviseur est composé d'une telle bascule simplifiée 12 ou de deux bascules simplifiées 12 et 14 comme montré à la figure 2, il est possible de réduire sa consommation électrique tout en permettant un fonctionnement à très haute fréquence.

A partir de la description qui vient d'être faite, plusieurs variantes du circuit compteur-diviseur double mode peuvent être conçues par l'homme du métier sans sortir du cadre de l'invention définie par les revendications. Le circuit compteur-diviseur double mode peut comprendre une succession de plusieurs ensembles diviseurs par 2 ou par 3. L'ensemble du circuit compteur-diviseur peut également être combiné avec une chaîne de diviseurs notamment par 2 de manière à pouvoir sélectionner un facteur parmi deux facteurs de division adéquats dans une boucle à verrouillage de phase d'un synthétiseur de fréquence. De préférence, l'ensemble diviseur par 2 ou par 3 se trouve en entrée du circuit compteur-diviseur.

## Revendications

1. Circuit compteur-diviseur double mode (1) pour opérer à très haute fréquence, le circuit comprenant au moins un ensemble composé d'une première et d'une seconde bascules dynamiques de type D (12, 13), et de deux portes logiques (15, 16) disposées en contre-réaction entre les deux bascules, qui sont cadencées par un signal d'horloge d'entrée (CK) afin de fournir un signal de sortie divisé (OUT) par la seconde bascule dont la fréquence correspond à la fréquence du signal d'horloge d'entrée divisée par un premier facteur égal à 2, ou par un second facteur égal à 3 en fonction d'un signal de sélection de mode de division (divb) appliqué en entrée d'une des portes logiques, une sortie (Q) de la seconde bascule (13) étant reliée à une entrée de la première bascule (12), **caractérisé en ce que** les deux portes logiques sont des portes du type ET inversé, et **en ce qu'**une des bascules dynamiques est composée de trois branches actives pour ne fournir qu'un seul signal de sortie inversée.

2. Circuit compteur-diviseur (1) selon la revendication 1, **caractérisé en ce que** la première porte logique ET inversé (15) est disposée pour recevoir le signal de sortie inversée (Qb) de la première bascule dynamique (12), qui ne comprend que trois branches actives, et le signal de sélection de mode de division (divb), **en ce que** la seconde porte logique ET inversé (16) est disposée pour recevoir le signal de sortie de la première porte logique ET inversé et le signal de sortie non inversée (Q) de la seconde bascule dynamique (13) afin de fournir un signal de sortie en entrée de la seconde bascule, le signal de sortie non inversée de la seconde bascule étant fourni en entrée de la première bascule dynamique.

3. Circuit compteur-diviseur (1) selon l'une des revendications précédentes, **caractérisé en ce que** le signal de sortie divisé (OUT) du circuit compteur-diviseur est fourni par une sortie inversée (Qb) de la seconde bascule (13).

4. Circuit compteur-diviseur (1) selon l'une des revendications précédentes, **caractérisé en ce qu'**il comprend une troisième bascule dynamique de type D (14) à une seule sortie inversée, qui est composée de trois branches actives, la troisième bascule recevant en entrée un signal inversé de sélection de mode de division (div) afin de fournir par la sortie inversée le signal de sélection de mode (divb) à la première porte logique ET inversé, cette troisième bascule étant cadencée par le signal de sortie non inversée de la seconde bascule.

5. Circuit compteur-diviseur (1) selon l'une des revendications 2 et 4, **caractérisé en ce que** la première et/ou la troisième bascule dynamique comprennent une première branche active, dans laquelle sont disposés en série, entre une borne positive (V_{DD}) et une borne négative (V_{SS}) de connexion à une source de tension continue, un premier et un second transistors PMOS (P1, P2), et un premier transistor NMOS (N1), une grille des premiers transistors PMOS et NMOS étant reliée pour constituer la borne d'entrée de la bascule, alors qu'une grille du second transistor PMOS reçoit un signal d'horloge (CK) pour cadencer la bascule, une seconde branche active, dans laquelle sont disposés en série un troisième transistor PMOS (P3) et des second et troisième transistors NMOS (N2, N3), une grille des troisièmes transistors PMOS et NMOS recevant le signal d'horloge, alors qu'une grille du second transistor NMOS est reliée aux drains du second transistor PMOS et du premier transistor NMOS, et une troisième branche active, dans laquelle sont disposés en série un quatrième transistor PMOS (P4) et des quatrième et cinquième transistors NMOS (N4, N5), une grille du quatrième transistor NMOS recevant le signal d'horloge, alors qu'une grille du quatrième transistor PMOS est reliée avec une grille du cinquième transistor NMOS aux drains du second transistor NMOS et du troisième transistor PMOS, le noeud de connexion des drains des quatrièmes transistors PMOS et NMOS fourni le signal de sortie inversée.

6. Circuit compteur-diviseur (1) selon la revendication 5, **caractérisé en ce que** la seconde bascule dynamique comprend trois branches actives comme les première et troisième bascules, et un étage inverseur pour fournir un signal de sortie non inversée.

7. Circuit compteur-diviseur (1) selon l'une des revendications précédentes, **caractérisé en ce qu'**il est réalisé sous forme intégrée dans un substrat de silicium dopé P dans une technologie CMOS à 0.18 µm.

8. Circuit compteur-diviseur (1) selon l'une des revendications précédentes, **caractérisé en ce qu'**il comprend, à la suite du premier ensemble diviseur par 2 ou par 3, une succession de diviseurs par 2 combinés avec d'autres ensembles diviseurs par 2 ou par 3, qui sont composés chacun d'au moins deux bascules dynamiques de type D, et de deux portes logiques ET inversé disposés en contre-réaction entre les deux bascules.

## Claims

1. Dual-modulus prescaler circuit (1) for operating at a very high frequency, said circuit including at least one assembly formed of first and second dynamic D-type flip flops (12, 13), and two logic gates (15, 16) arranged in negative feedback between the two flip flops, which are clocked by an input clock signal (CK) in order to supply a divided output signal (OUT) through the second flip flop, whose frequency matches the input clock signal frequency divided by a first factor equal to 2, or by a second factor equal to 3 as a function of a division mode selection signal (divb) applied to the input of one of the logic gates, one output (Q) of the second flip flop (13) being connected to one input of the first flip flop (12), **characterized in that** the two logic gates are NAND gates, and **in that** one of the dynamic flip flops is formed of three active branches so as to provide only one inverted output signal.

2. Prescaler circuit (1) according to claim 1, **characterized in that** the first NAND gate (15) is arranged for receiving the inverted output signal (Qb) from the first dynamic flip flop (12), which has only three active branches, and the division mode selection signal (divb), **in that** the second NAND gate (16) is arranged for receiving the output signal from the first NAND logic gate and the non-inverted output signal (Q) from the second dynamic flip flop (13) in order to supply an output signal to the input of the second flip flop, the non-inverted output signal from the second flip flop being provided to the input of the first dynamic flip flop.

3. Prescaler circuit (1) according to any one of the preceding claims, **characterized in that** the divided output signal (OUT) of the prescaler circuit is supplied by an inverted output (Qb) of the second flip flop (13).

4. Prescaler circuit (1) according to any one of the preceding claims, **characterized in that** it includes a third dynamic D-type flip flop (14) with a single inverted output, which is formed of three active branches, the third flip flop receiving at input an inverted division mode selection signal (div) in order to provide, via the inverted output, the mode selection signal (divb) to the first NAND logic gate, said third flip flop being clocked by the non-inverted output signal from the second flip flop.

5. Prescaler circuit (1) according to any one of claims 2 and 4, **characterized in that** the first and/or third dynamic flip flops include a first active branch, in which there are arranged, in series, between a positive terminal (V_{DD}) and a negative terminal (V_{SS}) connected to a continuous voltage source, first and second PMOS transistors (P1, P2), and a first NMOS transistor (N1), one gate of the first PMOS and NMOS transistors being connected to form the input terminal of the flip flop, whereas one gate of the second PMOS transistor receives a clock signal (CK) for clocking the flip flop, a second active branch, in which there are arranged, in series, a third PMOS transistor (P3) and second and third NMOS transistors (N2, N3), one gate of the third PMOS and NMOS transistors receiving the clock signal, whereas one gate of the second NMOS transistor is connected to the drains of the second PMOS transistor and the first NMOS transistor, and a third active branch, in which there are arranged, in series, a fourth PMOS transistor (P4) and fourth and fifth NMOS transistors (N4, N5), one gate of the fourth NMOS transistor receiving the clock signal, whereas one gate of the fourth PMOS transistor is connected with one gate of the fifth NMOS transistor to the drains of the second NMOS transistor and the third PMOS transistor, the drain connection node of the fourth PMOS and NMOS transistors suppliying the inverted output signal.

6. Prescaler circuit (1) according to claim 5, **characterized in that** the second dynamic flip flop includes three active branches like the first and third flip flops, and one inverter stage for supplying a non-inverted output signal.

7. Prescaler circuit (1) according to any one of the preceding claims, **characterized in that** it is integrated in a P-doped silicon substrate in 0.18 µm CMOS technology.

8. Prescaler circuit (1) according to any one of the preceding claims, **characterized in that** it includes, after the first divider-by-2 or divider-by-3 assembly, a series of dividers-by-2 combined with other divider-by-2 or divider-by-3 assemblies, which are each formed of at least two dynamic D-type flip flops, and two NAND gates arranged in negative feedback between the two flip flops.

## Patentansprüche

1. Doppelbetriebsart-Zähler/Teiler-Schaltung (1) für einen Betrieb bei sehr hoher Frequenz, wobei die Schaltung wenigstens eine Anordnung umfasst, die aus einem ersten und einem zweiten dynamischen D-Flipflop (12, 13) und aus zwei Logikgattern (15, 16) gebildet ist, die in Gegenkopplung zwischen den zwei Flipflops angeordnet sind, die durch ein Eingangstaktsignal (CK) getaktet werden, um ein durch das zweite Flipflop geteiltes Ausgangssignal (OUT) zu liefern, dessen Frequenz der Frequenz des Eingangstaktsignals, geteilt durch einen ersten Faktor, der gleich 2 ist, oder durch einen zweiten Faktor, der gleich 3 ist, gemäß einem Teilungsbetriebsart-Auswahlsignal (divb), das in den Eingang eines der Logikgatter eingegeben wird, entspricht, wobei ein Ausgang (Q) des zweiten Flipflops (13) mit einem Eingang des ersten Flipflops (12) verbunden ist, **dadurch gekennzeichnet, dass** die zwei Logikgatter Gatter vom NAND-Typ sind und dass eines der dynamischen Flipflops aus drei aktiven Zweigen gebildet ist, um nur ein einziges invertiertes Ausgangssignal zu liefern.

2. Zähler/Teiler-Schaltung (1) nach Anspruch 1, **dadurch gekennzeichnet, dass** das erste NAND-Logikgatter (15) dazu ausgelegt ist, das invertierte Ausgangssignal (Qb) des ersten dynamischen Flipflops, das nur drei aktive Zweige enthält, und das Teilungsbetriebsart-Auswahlsignal (divb) zu empfangen, dass das zweite NAND-Logikgatter (16) dazu ausgelegt ist, das Ausgangssignal des ersten NAND-Logikgatters und das nicht invertierte Ausgangssignal (Q) des zweiten dynamischen Flipflops (13) zu empfangen, um ein Ausgangssignal an den Eingang des zweiten Flipflops zu liefern, wobei das nicht invertierte Ausgangs-signal des zweiten Flipflops an den Eingang des ersten dynamischen Flipflops geliefert wird.

3. Zählerfreiler-Schaltung (1) nach einem der vorhergehenden Ansprüche, **dadurch gekennzeichnet, dass** das geteilte Ausgangssignal (OUT) der Zähler/Teiler-Schaltung von einem invertierten Ausgang (Qb) des zweiten Flipflops (13) geliefert wird.

4. Zähler/Teiler-Schaltung (1) nach einem der vorhergehenden Ansprüche, **dadurch gekennzeichnet, dass** sie ein drittes dynamisches D-Flipflop (14) mit einem einzigen invertierten Ausgang umfasst, das aus drei aktiven Zweigen gebildet ist, wobei das dritte Flipflop am Eingang ein invertiertes Signal für die Auswahl der Teilungsbetriebsart (div) empfängt, um das Betriebsartauswahlsignal (divb) durch den invertierten Ausgang zu dem ersten NAND-Logikgatter zu liefern, wobei dieses dritte Flipflop durch das nicht invertierte Ausgangssignal des zweiten Flipflops getaktet wird.

5. Zähler/Teiler-Schaltung (1) nach einem der Ansprüche 2 und 4, **dadurch gekennzeichnet, dass** das erste und/oder das dritte dynamische Flipflop einen ersten aktiven Zweig, in dem in Reihe zwischen einem positiven Anschluss (V_{DD}) und einem negativen Anschluss (V_{SS}) für die Verbindung mit einer Gleichspannungsquelle ein erster und ein zweiter PMOS-Transistor (P1, P2) und ein erster NMOS-Transistor (N1) geschaltet sind, wobei ein Gate des ersten PMOS-Transistors und des ersten NMOS-Transistors verbunden ist, um den Eingangsanschluss des Flipflops zu bilden, während ein Gate des zweiten PMOS-Transistors ein Taktsignal (CK) empfängt, um das Flipflop zu takten, einen zweiten aktiven Zweig, in dem in Reihe ein dritter PMOS-Transistor (P3) und ein zweiter und ein dritter NMOS-Transistor (N2, N3) geschaltet sind, wobei ein Gate des dritten PMOS-Transistors und des dritten NMOS-Transistors das Taktsignal empfängt, während ein Gate des zweiten NMOS-Transistors mit den Drains des zweiten PMOS-Transistors und des ersten NMOS-Transistors verbunden ist, und einen dritten aktiven Zweig, in dem in Reihe ein vierter PMOS-Transistor (P4) und ein vierter und ein fünfter NMOS-Transistor (N4, N5) geschaltet sind, wobei ein Gate des vierten NMOS-Transistors das Taktsignal empfängt, während ein Gate des vierten PMOS-Transistors zusammen mit einem Gate des fünften NMOS-Transistors mit den Drains des zweiten NMOS-Transistors und des dritten PMOS-Transistors verbunden ist, umfassen, wobei der Verbindungsknoten der Drains des vierten PMOS-Transistors und des vierten NMOS-Transistors das invertierte Ausgangssignal liefert.

6. Zähler/Teiler-Schaltung (1) nach Anspruch 5, **dadurch gekennzeichnet, dass** das zweite dynamische Flipflop wie das erste und das dritte Flipflop drei aktive Zweige und außerdem eine Inverterstufe, um ein nicht invertiertes Ausgangssignal zu liefern, umfasst.

7. Zähler/Teiler-Schaltung (1) nach einem der vorhergehenden Ansprüche, **dadurch gekennzeichnet, dass** sie in integrierter Form in einem P-dotierten Siliciumsubstrat in CMOS-Technologie mit 0,18 µm hergestellt ist.

8. Zähler/freiler-Schaltung (1) nach einem der vorhergehenden Ansprüche, **dadurch gekennzeichnet, dass** sie nach der ersten Teileranordnung durch 2 oder durch 3 eine Folge von Teilern durch 2, die mit anderen Teileranordnungen durch 2 oder durch 3 kombiniert sind, die jeweils aus wenigstens zwei dyna-mischen D-Flipflops und aus zwei NAND-Logikgattern, die in Gegenkopplung zwischen den zwei Flipflops angeordnet sind, gebildet sind, umfasst.
